(19) **European Patent Office**

**Europäisches Patentamt**

**Office européen des brevets**

(11) **EP 1 063 690 A1**

# (12) EUROPEAN PATENT APPLICATION
published in accordance with Art. 158(3) EPC

(43) Date of publication:
27.12.2000 Bulletin 2000/52

(51) Int. Cl.⁷: $H01L\ 21/31$, $H01L\ 21/205$

(21) Application number: 99907872.8

(86) International application number:
PCT/JP99/01079

(22) Date of filing: 05.03.1999

(87) International publication number:
WO 99/45585 (10.09.1999 Gazette 1999/36)

(84) Designated Contracting States:
BE DE FR GB IT

(30) Priority: 05.03.1998 JP 7333798
11.03.1998 JP 7839698

(71) Applicant:
Tokyo Electron Limited
Tokyo 107-8481 (JP)

(72) Inventors:
• AMANO, Hideaki
Zama-shi, Kanagawa 228-0002 (JP)

• OKA, Shinsuke
Sagamihara-shi, Kanagawa 229-1103 (JP)
• NAKASE, Risa
Sagamihara-shi, Kanagawa 229-0031 (JP)
• AOKI, Takeshi
Ebina-shi, Kanagawa 243-0411 (JP)
• AKAHORI, Takashi
Hachioji-shi, Tokyo 192-0362 (JP)

(74) Representative: Liesegang, Eva
Forrester & Boehmert,
Franz-Joseph-Strasse 38
80801 München (DE)

## (54) PLASMA PROCESSING APPARATUS AND PLASMA PROCESSING METHOD

(57) A process gas supply portion 5 of plasma processing apparatus has a plurality of process gas supply holes 55 for introducing process gas into a processing chamber 22. Each of the process gas introducing ports 55 has an axis A diagonally crossing a plane including a surface of a substrate W to be processed to be placed on a susceptor 4 at a specified crossing angle of θ. The axes of each process gas introducing ports 55 simultaneously cross each other at a position. The position is located on a normal line B at the center of the surface to be processed of the substrate W placed on a susceptor 4, and a distance L apart from the surface to be processed toward the plasma chamber 21. This configuration equalizes concentration distribution of the process gas above the substrate W.

F I G. 2

**Description**

BACKGROUND OF THE INVENTION

TECHNICAL FIELD

The present invention relates to a plasma processing apparatus and a method for performing deposition process or etching process on a substrate to be processed, more specifically, to a device and a way for supplying process gas such as deposition gas and etching gas into a vacuum vessel.

DESCRIPTION OF THE RELATED ART

One of methods for applying deposition or etching treatment on a semi-conductor wafer is a process utilizing plasma. This process is performed by introducing a process gas into a vacuum vessel equipped with a wafer susceptor and, for example, by supplying electromagnetic energy to this process gas to produce a plasma. As electromagnetic energy supplying technique, a method utilizing electron cyclotron resonance (ECR) that is an interaction between microwave and magnetic field Mf, and a method called ICP (Inductive Coupled Plasma) in which a coil wound on a dome-shaped vessel gives electric field and the magnetic field Mf to the process gas are known.

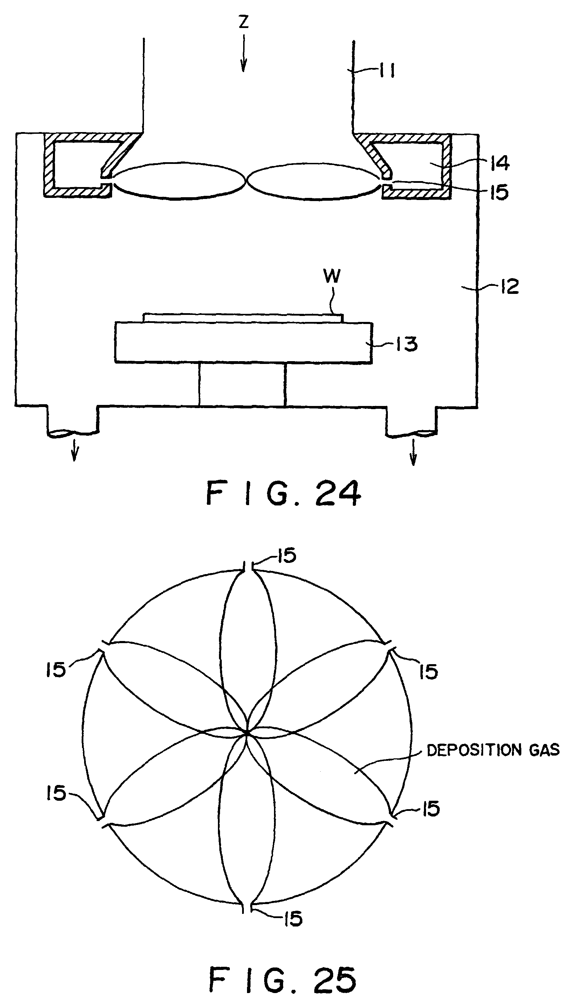

An example of conventional plasma processing apparatus utilizing the ECR is described by taking processing to form CF film (fluorine added carbon film) as an example based on Figure 24. Firstly, microwave at a frequency of 2.45 GHz is supplied into a plasma producing chamber 11 through a conductive wave tube (not shown), and high density plasma is produced from Ar gas (plasma gas) by simultaneously applying the magnetic field to the Ar gas using an electromagnetic coil (not shown) to utilize the interaction between the microwave and the magnetic field Mf. Active species is produced by activating deposition gas ($C_4F_8$ gas and $C_2H_4$ gas) introduced into a deposition chamber 12, and a CF film is formed on a surface of the semiconductor wafer W (hereafter referred to as "Wafer W") placed on the susceptor 13.

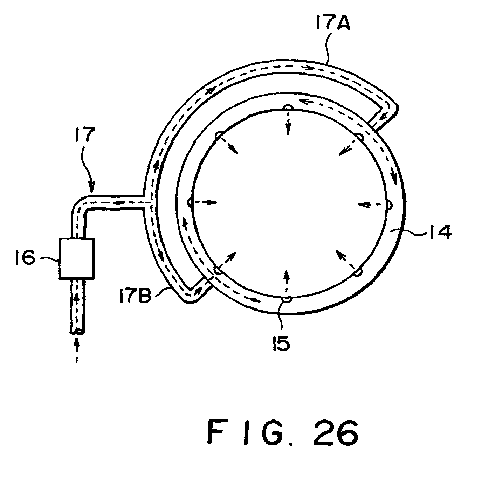

At this time, the deposition gas is supplied through a deposition gas supply portion 14. The deposition gas supply portion 14 is formed as a hollow ring shape, and its inside peripheral is provided with a plurality of gas introducing holes 15 almost equally spaced circumferentially. Each gas supply hole 15 is arranged so that it is nearly parallel to a surface of the wafer W to be processed and an outlet side of it faces the center of the deposition chamber 12. Each gas supply hole 15 has the same diameter from an inlet side through the outlet side. Figure 26 shows a conventional deposition gas supply system. In this gas supply system, the deposition gas is supplied from a gas supply source (not shown) through a gas supply pipe 17. The gas supply pipe 17 is equipped with a mass flow controller 16 for adjusting a flow rate of the deposition gas. The gas supply pipe 17 branches off to two ways at a downstream side of the mass flow controller 16. And the gas supply pipe branches 17A and 17B are connected to the deposition gas supply portion 14 at the positions 180 deg. apart from each other. Length of the gas supply pipes 17A and 17B are normally not identical for the convenience of layout.

Recently equipment capable of depositing uniform film on the wafer W has been required with the enlargement of wafer W diameter. It is important to introduce the deposition gas as uniformly as possible into a space above the surface of the wafer W to be processed in order to secure in-plane uniformity of the formed film. However, conventional plasma processing apparatus has the following problems:

Firstly, since the inlet side through the outlet side of each gas supply hole 15 are arranged on the circle having the same diameter, the deposition gas disperses as a beam slenderly elongating from the gas supply holes 15 horizontally, and does not three-dimensionally disperse taking an axis of the gas supply hole 15 as a center. Therefore, viewing from the direction perpendicular to the surface of the wafer W to be processed, distribution of the deposition gas becomes unequal as shown in Fig. 25.

Since flow resistance of the gas supply pipes 17A and 17B are different from each other due to the length difference of the gas supply pipes 17A and 17B, the flow rates of gas supplied from each of the gas supply pipes 17A and 17B to the deposition gas supply portion 14 are different from each other. Therefore, discharge rates of the deposition gas from each gas supply hole are different.

Furthermore, when different types of gas such as $C_4F_8$ gas and $C_2H_4$ gas are supplied, the $C_2H_4$ gas having relatively low specific gravity has directivity of narrow beam. On the other hand, the $C_4F_8$ gas having relatively high specific gravity easily disperses three-dimensionally taking the axis of the gas supply hole 15 as the center. This difference of dispersion directivity results in unequal distribution of both gas above the surface of the wafer W to be processed.

For the above reasons, the conventional plasma processing apparatus does not provide sufficient uniformity of film thickness and film property in the processed surface. In addition, the etching process has also similar problem caused by unequal gas distribution above the surface to be processed.

**EP 1 063 690 A1**

SUMMARY OF THE INVENTION

The object of the invention is to provide a plasma processing apparatus that can improve uniformity in the processed surface by improving uniformity of process gas distribution above the surface to be processed when performing the plasma processing by supplying process gas to a substrate through gas supply holes.

In order to achieve the above object, the present invention provides the plasma processing apparatus which includes: a plasma chamber for producing plasma: a processing chamber connected to the plasma chamber and into which the plasma produced in the plasma chamber is introduced; a plasma gas introducing means for introducing the plasma gas into the plasma chamber, a susceptor arranged in the processing chamber to place a substrate to be processed; and a process gas introducing means for the processing chamber having a plurality of process gas introducing ports for supplying the process gas to the processing chamber, wherein each of the process gas introducing ports has an axis diagonally crossing a plane including a surface of the substrate to be processed placed on the susceptor at a specified crossing angle.

A cross-sectional area of the process gas introducing port may be configured so that it increases as it approaches to an outlet end toward the processing chamber.

The process gas introducing ports can be arranged so that axes of the respective introducing ports cross each other at a position, which is on a normal line at a center of a surface to be processed of the substrate placed on the susceptor, and the position is a specified distance apart from the surface to be processed toward the plasma chamber. In this case, an angle between the axes of the process gas introducing ports and a plane including the surface to be processed of the substrate is preferably 15 to 65 deg., and the distance from the surface to be processed to the position at which the axes of the respective process gas introducing ports cross each other is preferably 5 to 15 mm. More preferably, the angle that the axis of the process gas introducing port forms with the plane including the surface to be processed of the substrate is 30 to 45 deg., and the distance from the surface to be processed to the position where the axes of the process gas introducing ports cross each other is 5 to 10 mm.

The axis of each of the process gas introducing port can be arranged so as not to cross the normal line at the center of the surface to be processed of the substrate placed on the susceptor.

Furthermore, outlet ends of the process gas introducing ports can be located at the external part of a plasma emission zone.

The process gas introducing means for the processing chamber can be formed as a hollow ring body having an inside peripheral surface, the body having a ring shape taking the normal line at the center of the surface to be processed of the substrate placed on the susceptor as a central axis. In this case, process gas passages for passing the process gas extending along the circumferential direction of the ring body is formed inside the ring body, and the process gas passages of the ring body are connected to the process gas introducing port and opens toward the inside peripheral surface.

The plasma processing apparatus can be configured so as to be further includes a plurality of gas introducing passages connected, with intervals with respect to a circumferential direction of the process gas passage, to the process gas passage of the ring body; and a flow control device installed in each of the gas introducing passages.

The plasma processing apparatus can be also configured so as to be further equipped with the process gas introducing means for the plasma chamber for supplying the process gas to the plasma chamber, and so as to convert the process gas supplied to the plasma chamber to an active species by the process gas introducing means for the plasma chamber. In this case, the process gas supplied to the plasma chamber by the process gas introducing means for the plasma chamber can be provided with the same composition as the process gas supplied to the processing chamber by the process gas introducing means for the processing chamber, and the process gas supplied to the plasma chamber by the process gas introducing means for the plasma chamber can be provided with the composition different from the process gas supplied to the processing chamber by the process gas introducing means for the processing chamber.

When the plasma processing apparatus comprises a means for supplying microwave to the plasma chamber and a means for generating magnetic field in the plasma chamber, the apparatus can be configured so that the outlet end of each gas introducing port of the process gas introducing means for the plasma chamber is located at the position opposite to the processing chamber beyond the zone where electron cyclotron resonance condition within the plasma chamber is established.

The gas introducing port of the process gas introducing means for the processing chamber can be configured so as to include a first gas introducing port, and a second gas introducing port that is located in the position lower than that of the first gas introducing port and is arranged so that the distance from the normal line at the center of the surface of the substrate to be processed to be placed on the susceptor to the outlet end of the second gas introducing port is larger than that from the normal line to the outlet end of the first gas introducing port. In this case, it is preferable to make the specific gravity of the process gas supplied through the first gas introducing port larger than that of the process gas supplied through the second gas introducing port.

The process gas introducing means for the processing chamber can be formed as a hollow ring body having an inside peripheral surface, the body having a ring shape taking the normal line at the center of the surface to be processed of the substrate placed on the susceptor as a central axis. In this case, the means can be configured so that the first process gas passage and the second process gas passage circumferentially extending along the ring-shaped body are provided inside the ring-shaped body, the first and second process gas passages are independent from each other to prevent the gas flowing from one passage to the other, the first gas introducing port is connected to the first process gas passage and opens toward the inside peripheral surface of the ring-shaped body, and the second gas introducing port is connected to the second process gas passage and opens toward the inside peripheral surface of the ring-shaped body.

According to the second aspect of the present invention, a plasma processing method including a process for placing the substrate to be processed on the susceptor arranged in the processing chamber, a process for supplying the process gas in the direction diagonally crossing the plane including the surface to be processed from a plurality of positions against the surface of the substrate to be processed and a process for producing plasma from the process gas to perform plasma processing on the substrate are provided.

The processing to be performed on the substrate to be processed by the plasma processing apparatus may be either deposition processing or etching processing.

BRIEF DESCRIPTION OF DRAWINGS

Fig. 1 is a cross-sectional view illustrating an embodiment of plasma processing apparatus related to the present invention;

Fig. 2 is an enlarged cross-sectional view illustrating a configuration of a gas supply portion and a geometrical arrangement relation between a substrate and a gas supply hole in the plasma processing apparatus shown in Fig. 1;

Fig. 3 is a plan view illustrating the geometrical arrangement relation between the substrate and the gas supply hole shown in Fig. 2;

Fig. 4 is an enlarged cross-sectional view showing a cross-sectional shape of the gas supply hole;

Fig. 5 is an enlarged cross-sectional view showing the other embodiment of the gas supply hole;

Fig. 6 is an enlarged cross-sectional view showing the other example of a structure of a buffer chamber in a process gas supply portion;

Fig. 7 is a side cross-sectional view illustrating directivity of deposition gas ejected through the gas supply hole of the present invention;

Fig. 8 is a diagrammatic plan view illustrating the directivity of the deposition gas ejected through the gas supply hole of the present invention and viewed from the Z direction shown in Fig. 7;

Fig. 9 is a view illustrating the other embodiment having the gas supply holes in a different direction;

Fig. 10 is a cross-sectional view of the main portion illustrating the other embodiment of the plasma processing apparatus wherein the relation between the process gas supply portion and plasma emission zone is specified;

Fig. 11 is a cross-sectional view illustrating the other embodiment of the plasma processing apparatus wherein the construction of the process gas supply portion is changed;

Fig. 12 is a cross-sectional view illustrating the construction of the process gas supply portion of the plasma processing apparatus shown in Fig. 11;

Fig. 13 is a diagram illustrating an ejecting condition of the process gas when the process gas supply portion shown in Fig. 12 is used;

Fig. 14 is a diagram illustrating concentration distribution of the process gas directly above a wafer when the process gas is ejected as shown in Fig. 13;

Fig. 15 is a diagram illustrating the ejecting condition of the process gas when a plurality of types of the process gas is mixed in the process gas supply portion and ejected through a common gas supply hole (example for comparison);

Fig. 16 is a diagram illustrating the concentration distribution of the process gas directly above the wafer when the process gas is ejected as shown in Fig. 15;

Fig. 17 is a diagrammatic plan view illustrating the other embodiment of the plasma processing apparatus wherein a supply system for supplying the process gas to the process gas supply portion is changed;

Figs. 18A, 18B, 18C and 18D are diagrammatic plan views illustrating the process gas supply system of the plasma processing apparatus used in a test;

Fig. 19 is a chart illustrating test results by the plasma processing apparatus shown in Fig. 18A through Fig. 18D and uniformity of film thickness;

Fig. 20 is a cross-sectional view illustrating the other embodiment of the plasma processing apparatus configured so that the process gas can be partially introduced to the plasma chamber;

Figs. 21A, 21B and 21C are explanatory views illustrating the manner in which $C_4F_8$ gas is dissociated by the plasma when CF film is formed using the plasma processing apparatus shown in Fig. 20;

Figs. 22A, 22B and 22C are explanatory views illustrating the manner in which $C_4F_8$ gas is dissociated by the plasma when CF film is formed using conventional plasma processing apparatus;

Fig. 23 is a cross-sectional view showing an example where the invention applies to ICP type of plasma processing apparatus;

Fig. 24 is a diagrammatic cross-sectional view illustrating conventional plasma processing apparatus;

Fig. 25 is a diagrammatic plan view illustrating the directivity of the process gas ejected through the gas supply hole of the plasma processing apparatus shown in Fig. 24 and viewed from the Z direction shown in Fig. 24; and

Fig. 26 is a diagrammatic plan view illustrating a construction of the process gas supply system of the conventional plasma processing apparatus.

## DESCRIPTION OF THE PREFERRED EMBODIMENTS

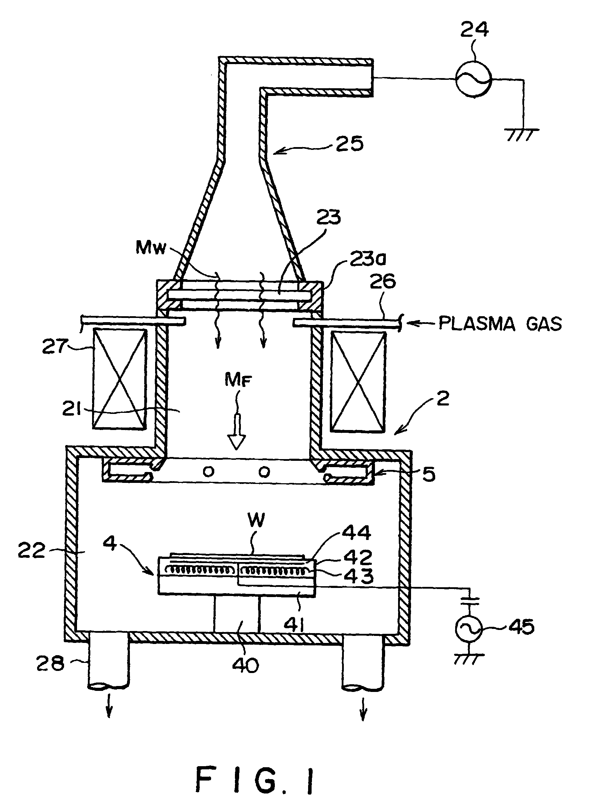

A preferred embodiment of plasma processing apparatus according to the present invention will be described referring to Fig. 1 through Fig. 7. As shown in Fig. 1, the plasma processing apparatus has a vacuum vessel 2 made of aluminum or the like. The vacuum vessel 2 has a plasma chamber 21 in which plasma is produced and a processing chamber 22 located under the plasma chamber 21 and communicated with the plasma chamber 21. The vacuum vessel 2 is grounded to make electric potential zero.

This vacuum vessel has an opening at the top thereof, and this opening is provided with a transmissive window 23 in an air-tight manner. The window 23 formed of a material which is transmissive to high frequency wave (microwave). The transmissive window 23 is made, for example, of aluminum nitride (A1N). The outside peripheral of the transmissive window 23 is supported by a support ring 23a in the air-tight manner. The transmissive window 23 and the support ring 23a maintain a vacuum condition inside the vacuum vessel 2.

The top of the transmissive window 23 is provided with a wave guide 25 to supply microwave at a frequency of, for example, 2.45 GHz into the plasma chamber 21. The wave guide 25 can be configured by combining a rectangular wave guide, a cylindrical wave guide and a conical wave guide. The outlet end of the wave guide 25 is connected to the top of the transmissive window 23, and the inlet end of the wave guide 25 is connected to a high frequency electric source 24. The wave guide 25 guides microwave generated in the high frequency electric source 24 in TE mode, or converts the microwave guided in the TE mode to TM mode, to introduce the microwave into the plasma chamber through the transmissive window 23.

Gas nozzles 26 are circumferentially arranged and equally spaced on the upper part of a side wall defining the plasma chamber 21. A plasma gas source (not shown) is connected to the gas nozzles 26. The gas nozzles 26 is capable of supplying plasma gas such as Ar gas and $O_2$ gas to the upper space of the plasma chamber 21 uniformly without irregularity. Further, although only two gas nozzles are shown on the drawing to avoid complexity, the actual number of the gas nozzles is more than that.

A ring-shaped main electromagnetic coil 27 having a ring shape is arranged around the plasma chamber 21 close to the outside peripheral of the side wall defining the plasma chamber 21. A ring-shaped auxiliary electromagnetic coil (not shown) is also arranged on the lower part of the processing chamber 22. These coils can generate magnetic field Mf (for example magnetic field at 875 Gauss) over the plasma chamber 21 and the processing chamber 22 directed downward.

A susceptor 4 for placing and holding thereon a wafer W is installed on a cylindrical support member 40 inside the processing chamber 22. The susceptor 4 comprises a dielectrics plate 42, in which a heater 43 and an electrode 44 is built, placed on a susceptor body 41. The loading surface of the susceptor 4 is configured as an electrostatic chuck:. A DC electric source for the electrostatic chuck (not shown) is connected to the electrode 44, to which a high frequency electric source 45 for applying bias voltage to introduce ion into the wafer W is also connected. Further, exhaust pipes 28 are connected to the bottom of the processing chamber 22. The susceptor 4 used is of a fixed type without elevating function. A substrate to be processed, namely the wafer W, can be placed on the susceptor 4 by a carrying arm with an elevation function (not shown).

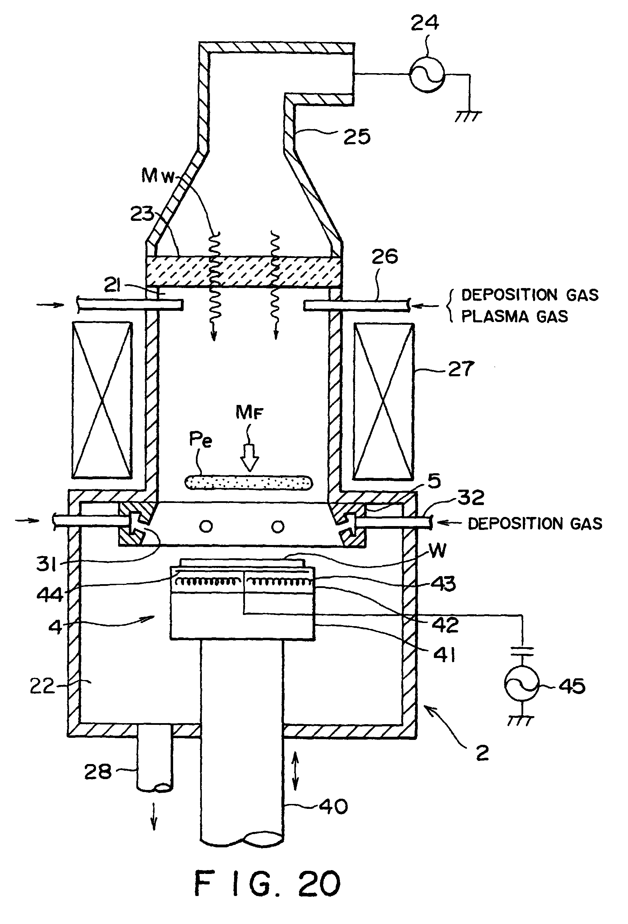

In addition, the susceptor can be configured so as to be capable of elevating between a processing position and a loading/unloading position. In this case, the support member 40 is configured so as to penetrate through the bottom wall of the vacuum vessel 2 and to be capable of elevating while keeping air-tightness inside the vacuum vessel 2 (See embodiments shown in Fig. 11 and Fig. 20 to be described later).

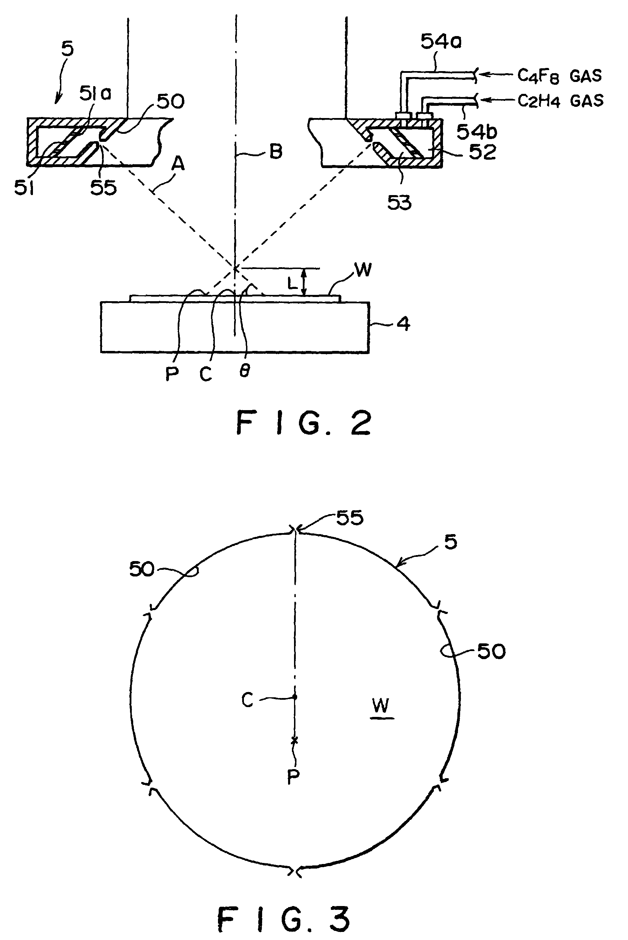

On the other hand, the upper part of the processing chamber 22, namely the portion connected to the plasma chamber 21, is provided with a process gas supply portion 5 having a hollow ring shape for introducing the process gas into the processing chamber 22. The internal space of the process gas supply portion 5 is divided, with respect to the radial direction of the ring, into two sections by a buffer plate 51. The buffer plate 51 is provided with gas holes 51a as shown in Fig. 2, and therefore a buffer chamber 52 and a gas chamber 53 are formed at the external side and internal side respectively in the process gas supply portion 5. Process gas supply pipes 54 (54a and 54b) are connected to the buffer chamber 52. The process gas (in this example, the process gas is a deposition gas for forming film) can be supplied from the process gas source to the buffer chamber 52 through these process gas supply pipes 54a and 54b. The buffer chamber 52 and the gas chamber 53 extending circumferentially plays a role of a process gas passage for allowing the process gas supplied through the process gas supply pipes to circumferentially flow in the process gas supply portion 5.

The process gas supply portion 5 has an inside peripheral surface 50 inclining so as to gradually flare as it goes downward. In this embodiment, the inside peripheral surface 50 is a part of a conical surface of a cone. The cone has a bottom plane including the surface to be processed of the wafer W placed on the susceptor 4, and an apex on the normal line at the center C of the wafer W to be processed. Note that "the normal line at the center of the surface of the substrate to be processed" is also referred to as "the central axis of the wafer."

A plurality of (in this embodiment, six) gas supply holes 55 is formed at the inside peripheral surface 50 equi-spaced around a circumference of the surface 50. The gas supply holes 55, in other words, the process gas introducing holes, are provided so that an axis A of each gas supply holes 55 shown by a dashed line in Fig. 2 diagonally crosses the surface of the wafer W to be processed placed on the susceptor 4 at an angle $\theta$, and axes A cross at the position the distance L apart from the wafer W upward (toward the gas supply hole 55) on the central axis of the wafer W shown by a chain line in Fig. 2.

In the above arrangement, the axes A of the gas supply holes 55 crosses the wafer at the position P beyond the center C of the surface to be processed of the wafer W when viewed from the gas supply hole 55. In addition, axes A do not cross each other on the wafer W.

In the embodiment shown in Fig. 2, the axis A of each gas supply holes 55 crosses the surface to be processed of the wafer W, however, the axis A of each gas supply hole 55 may cross the plane including the surface to be processed of the wafer W at an external position of the surface to be processed of the wafer W in the manner described above.

Combination of the angle $\theta$ at which the axis A of the gas supply hole 55 crosses the surface of the wafer W to be processed and the distance L from the surface of the wafer W to be processed to the point at which each axis crosses each other is preferably 15 deg. $\leqq \theta \leqq$ 65 deg. and 5 mm $\leqq L \leqq$ 15 mm respectively, and more preferably 30 deg. $\leqq \theta \leqq$ 45 deg. and 5 mm $\leqq L \leqq$ 10 mm respectively (See embodiments to be described later). The inclination of the inside peripheral surface 50 in the process gas supply portion 5 and the position of the gas supply holes 55 are set to meet this condition.

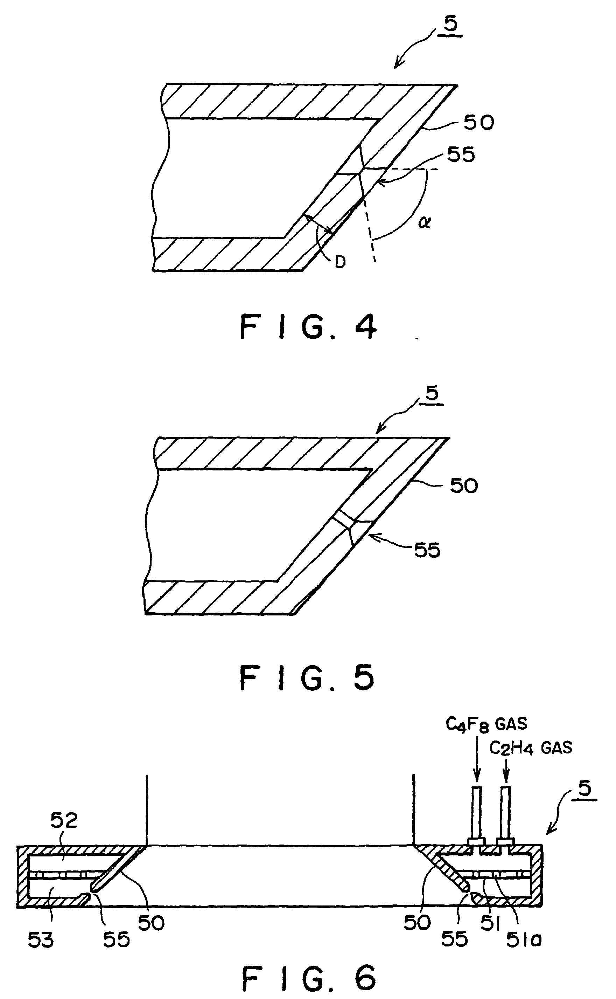

Especially as shown in Fig. 4 in detail, each gas supply hole 55 is configured so as to enlarge at an angle $\alpha$ as it goes from the position almost in the middle of a wall thickness D of the inside peripheral surface 50 to the outlet end (toward the center of the processing chamber 22), and also to enlarge as It goes from the position almost in the middle of a wall thickness D of the inside peripheral surface 50 to the inlet end. In other words, each gas supply hole 55 has a shape created by combining the two truncated cones.

In the embodiment shown in Fig. 4, the thickness D is approximately 4 mm, and an inner diameter of the gas supply hole 55 almost at the middle of the thickness D is 2 mm. In addition, the angle $\alpha$ is preferably set at 30 to 150 deg. The actual angle can be selected from the values within this range according to dispersion characteristic of the process gas ejected through the gas supply holes 55.

A shape of the gas supply hole 55 can be configure as a cylindrical one so that the inner diameter of the portion from the position almost in the middle of a wall thickness D of the inside peripheral surface 50 to the inlet end is constant as shown in Fig. 5 instead of the shape shown in Fig. 4. In this case also, the shape of the outlet side of the gas supply hole 55 is similarly configured as that shown in Fig. 4.

In the embodiment shown in Fig. 2, the buffer plate 51 is arranged in parallel with the inside peripheral surface 50 and the buffer chamber 52 is provided outside the gas chamber 53. Instead of this, an internal space of the process gas supply portion 5 can be horizontally divided into two sections by the buffer plate 51 to form the buffer chamber 52 at the upper portion and the gas chamber 53 at the lower portion respectively.

Then operation of the above-mentioned plasma processing apparatus is described taking the case of forming inter-level isolation film consisting of, for example, fluorine added carbon film (hereafter referred to as "CF film") on the wafer W, namely the substrate to be processed, as an example.

Firstly, a gate valve (not shown) installed on the side wall of the vacuum vessel 2 is opened. Next, the wafer W of, for example, 8 inch size on which surface aluminum wiring is formed is carried from a load lock chamber (not shown) into the vacuum vessel 2 by the carrying arm (not shown) and placed on the susceptor 4.

Then the gate valve is tightly closed. Internal atmosphere is exhausted through an exhaust pipe 28 to create a vacuum condition having the specified vacuum pressure. Then Ar gas (plasma gas) is introduced into the plasma chamber 21 through the gas nozzle 26 at the specified flow rate. Further, $C_4F_8$ gas and $C_2H_4$ gas are introduced as deposition gas into the processing chamber 22 from the process gas supply portion 5 at the specified flow rate respectively. And in a condition that a pressure inside the vacuum vessel 2 is maintained at the specified process pressure, bias voltage at 13.56 MHz is applied to the susceptor 4 by a high frequency electric source 45, and a surface temperature of the susceptor 4 is set, for example, at 400°C.

High frequency wave (microwave) Mw at 2.45 GHz from the high frequency electric source 24 reaches a ceiling part of the vacuum vessel 2, and is introduced into the plasma chamber 21 through the transmissive window 23. On the other hand, magnet field Mf is formed in the vacuum vessel 2 by the main electromagnetic coil 27 and the auxiliary electromagnetic coil (not shown). At the point where an intensity of the magnetic field Mf becomes 875 Gauss, electron cyclotron resonance is generated by an interaction between the magnetic field Mf and the microwave Mw. The electron cyclotron resonance ionizes the plasma gas to convert the gas into a plasma state having high density. Application of the plasma gas contributes to stabilize the plasma.

The produced plasma flows from the plasma chamber 21 into the processing chamber 22 as a plasma flow. The $C_4F_8$ gas and $C_2H_4$ gas supplied to the processing chamber 22 is activated (the gas is converted into a plasma state) to form active species (plasma). On the other hand, plasma ion is introduced into the wafer W by the bias voltage, and cuts off an edge of the CF film accumulated on a pattern (concave part) of the surface of the wafer W by a spatter etching action of plasma ion to increase width. Along with this spatter etching action, the plasma of the deposition gas forms the CF film to make it embedded in the concave. In this manner, the inter-level isolation film consisting of the CF film is formed.

Now the manner of supply of the deposition gas supplied from the process gas supply portion 5 to the processing chamber 22 is described in detail using Fig. 2. Firstly, the $C_4F_8$ gas and $C_2H_4$ gas supplied from the process gas supply pipes 54a and 54b respectively to the buffer chamber 52 disperse toward the gas chamber 53 through the gas hole 51a, and blow out through the gas supply hole 55 into the processing chamber 22.

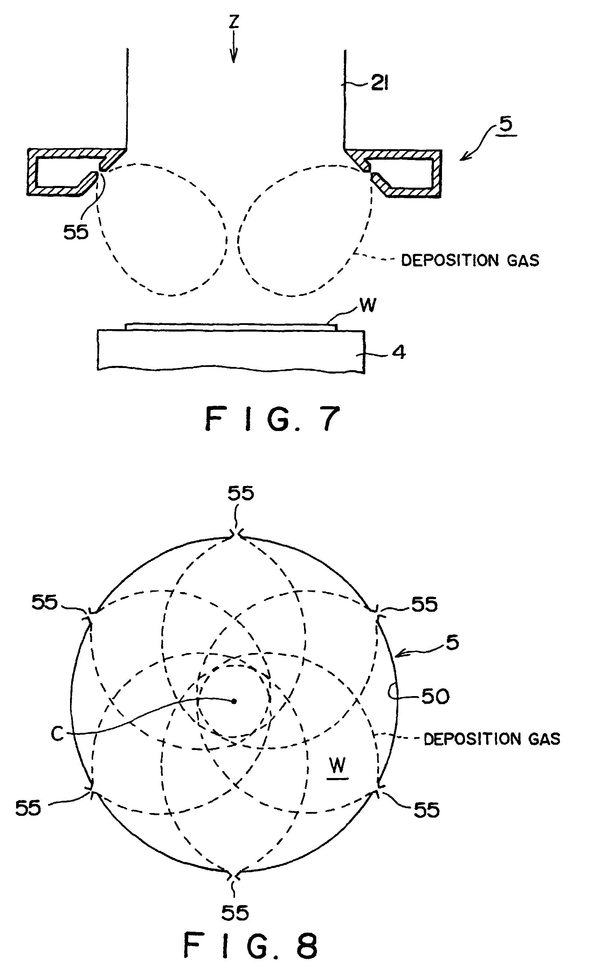

At this time, since each gas supply hole 55 is formed so that its inner diameter enlarges toward the outlet side, the deposition gas can easily disperse not only in the direction of the axis A of the gas supply hole 55 but three-dimensionally from the axis A as a center. That is to say, the deposition gas disperses with directivity of expanding while inflating, namely with wide directivity. Since the axis A diagonally crosses the wafer W at an angle of θ, the deposition gas diagonally blows out downward through each gas supply hole 55 with the aforementioned directivity as shown in Fig. 7. Since the axes A of the respective gas supply holes 55 are configured so as to cross at the position the distance L upward from the wafer W on the central axis B of the wafer W, the deposition gas blowing out through each gas supply hole 55 is supplied so as to reach the position P on the surface of the wafer W while crossing at the position where the axis A crosses each other (See Fig. 2).

When the deposition gas is supplied in this manner, the $C_4F_3$ gas and $C_2H_4$ gas are dispersed by the buffer plate 51 at the time of flowing from the buffer chamber 52 to the gas chamber 53, and further dispersed at the time of flowing from the gas chamber 53 the processing chamber 22 through the gas supply holes 55. Therefore, in comparison with the configuration without the buffer chamber 52, these several types of the deposition gas are supplied to the processing chamber 22 in a sufficiently mixed condition.

Therefore, a phenomenon that occurs when these deposition gas is not sufficiently mixed, namely a phenomenon where the concentration of the $C_4F_8$ gas is high while that of the $C_2H_4$ gas low in a certain area and the concentration of the $C_4F_8$ gas is low while that of the $C_2H_4$ gas high in the other area, is generated less frequently. Since this results in a situation that concentration distribution of carbon and fluorine in the CF film formed on the wafer W becomes almost uniform in the surface, uniformity of CF film property can be improved. Since the $C_4F_8$ gas and $C_2H_4$ gas do not react only by mixing, this type of configuration is effective.

Since the deposition gas disperses while expanding three-dimensionally from the axis of the gas supply holes 55 as the center, the deposition gas disperses in the embodiment shown in Fig. 8. Therefore, in comparison with the case of directivity of the deposition gas extending in a beam shape, namely the case of dispersion with narrow directivity (See Fig. 24 and Fig. 25), the deposition gas disperses in a wider zone. Therefore the concentration distribution of the deposition gas is equalized because the deposition gas can also spread to the peripheral part of the wafer easily. This results in an improvement of uniformity of thickness and in-plane property of the CF film to be formed.

Furthermore, since the axis A of each gas supply hole 55 does not cross each other on the surface of the wafer, a singular point at which the deposition gas concentrates on the surface of the wafer is not produced. Therefore it does not happen that film thickness on a particular place of the wafer W becomes extremely larger than that on the other place. That is to say, since the axis A of each gas supply hole 55 crosses each other at the position the distance L higher than the wafer W on the central axis B of the wafer W, the deposition gas blowing out through each gas supply hole 55 does not concentrate on the reaching point Pe on the surface of the wafer W, and an area where gas blowing out through each gas supply hole 55 overlaps becomes comparatively large because of the directivity of gas spreading while expanding. Therefore, the point on the wafer W directly under this overlapping area has no possibility to become the singular point of the CF film thickness. Since the point on the wafer W corresponding to the overlapping area of the deposition gas never becomes the singular point of the film thickness like this, this is also an advantage to improve the uniformity of the CF film thickness.

Since we have recognized that, when the distance L is smaller than 5 mm or larger than 15 mm, the film thickness is affected even the overlapping area of the deposition gas is located above the wafer W by tests to be described later, it is preferable to set the distance L from 5 mm or more to 15 mm or less.

By the way, it may be possible to avoid the deposition gas from overlapping with each other to improve the in-plane uniformity of the film thickness. This is achieved by allowing the axis A to cross the wafer surface at the point located near side of the center of the wafer W viewing from the gas supply hole 55. However in this kind of configuration, the CF film thickness becomes thin at the central area because the gas supply rate at the center of the wafer W becomes low, and, as a result, the in-plane uniformity of the film thickness becomes worse.

Now, a test example performed actually by the inventors to confirm an advantage of the first embodiment is described. Vacuum processing apparatus shown in Figs. 1, 2 and 4 was used. A test to produce CF film on the wafer W of 8-inch size was performed. At this time, Ar gas was introduced to the plasma chamber 21 at the specified flow rate, and the $C_4F_8$ gas and $C_2H_4$ gas were introduced to the processing chamber 22 at the specified flow rate. High frequency power was set at 2500 W, bias power at 1500 W, and pressure inside the vacuum vessel at 0.2 Pa.

The angle θ of the gas supply holes 55 of the process gas supply portion 5 was changed in the range of 10 to 80 deg. and the distance L was changed in the range of 0 to 20 mm to prepare a plurality of samples. And film thickness distribution of the obtained samples was measured by an Opti-probe to investigate film profile.

As a result of this test, it was confirmed that the smaller the angle θ becomes, the larger the film thickness at the central part becomes than that of the peripheral part, and the larger the angle θ becomes, the smaller the film thickness at the central part becomes than that of the peripheral part. In addition, from the test performed by changing the distance L, it was confirmed that when L is smaller than 5 mm, an amount of deposition at the center increases, and when L is larger than 15 mm, an amount of deposition at the peripheral increases. The reason of this phenomenon is considered that when L is smaller than 5 mm, joining point of the deposition gas approaches too close to the wafer surface, the gas through each gas supply hole 55 overlaps in the almost same condition as the case in which the axes A of respective gas supply holes 55 crosses each other on the wafer surface, and the singular point is easily generated at the central part. On the other hand, it is considered that, when L is larger than 15 mm, the distance between the center C of the wafer and the position P becomes too large, and void is easily generated at the central part.

Table 1 shows evaluation results of the uniformity of the film thickness for each condition. The in-plane uniformity was evaluated by calculating mean values and standard deviations σ of the film thickness at a plurality of measuring points (49 points this time) set so that the points are equally spaced on the surface of the wafer to be processed and by taking "3σ /mean value (%)" as an index representing the uniformity in the processed surface. In addition, the area 3 mm inward from the peripheral of the wafer W was excluded from the location of the measuring points.

Table 1

| Angle θ deg | L=0 mm | L=5 mm | L=10 mm | L=15 mm | L=20 mm |
|---|---|---|---|---|---|
| 10 | 10.3 | 8.3 | 9.1 | 8.1 | 11.3 |
| 15 | 9.8 | 4.8 | 5.3 | 5.7 | 10.2 |
| 30 | 9.1 | 4.6 | 4.1 | 5.5 | 9.3 |
| 45 | 8.5 | 4.5 | 4.2 | 6.2 | 8.2 |
| 60 | 8.9 | 4.2 | 5.1 | 6.3 | 7.9 |
| 63 | 9.6 | 5.0 | 5.2 | 6.9 | 8.1 |
| 65 | 10.4 | 5.8 | 5.4 | 7.1 | 8.5 |
| 70 | 12.5 | 9.2 | 5.8 | 7.3 | 9.1 |
| 80 | 30.1 | 22.0 | 10.0 | 10.5 | 12.1 |

When Table 1 is viewed based on the above analysis results, it is understood that it is preferable to combine the angle θ of 15 deg.≦ θ ≦ 65 deg. and the distance L of 5 mm≦L≦15 mm and it is more preferable to combine the angle θ of 30 deg.≦ θ ≦ 45 deg. and the distance L of 5 mm≦L≦10 mm in order to improve the uniformity of the film thickness.

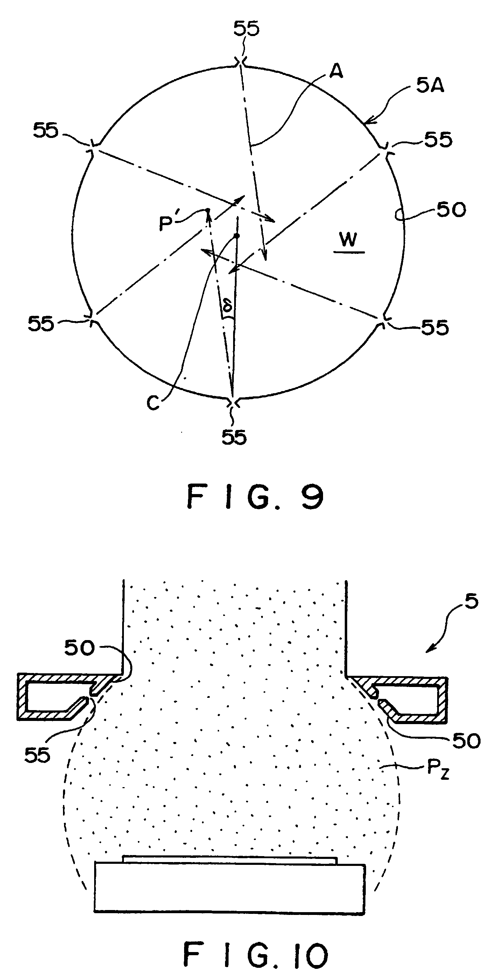

Now, another other embodiment of the gas supply holes 55 is described referring to Fig. 9. In the embodiment shown in Fig. 9, the axis A of each gas supply hole 55 inclines at an angle of δ from the straight line connecting the gas supply hole 55 and the center of the wafer W in order to avoid passing through the central axis B of the wafer W viewed from the direction of the central axis B of the wafer W. The axes A of respective gas supply holes 55 crosses the wafer at the position P' locating far side of the center of the surface of the wafer W to be processed viewed from the gas supply hole 55.

Since the axes A does not cross each other on the surface of the wafer W and the axes does not cross the wafer surface at the position locating near side of the center C even in this configuration, the deposition gas concentration does not become high or low at the particular location. Therefore the uniformity of the CF film thickness can be improved.

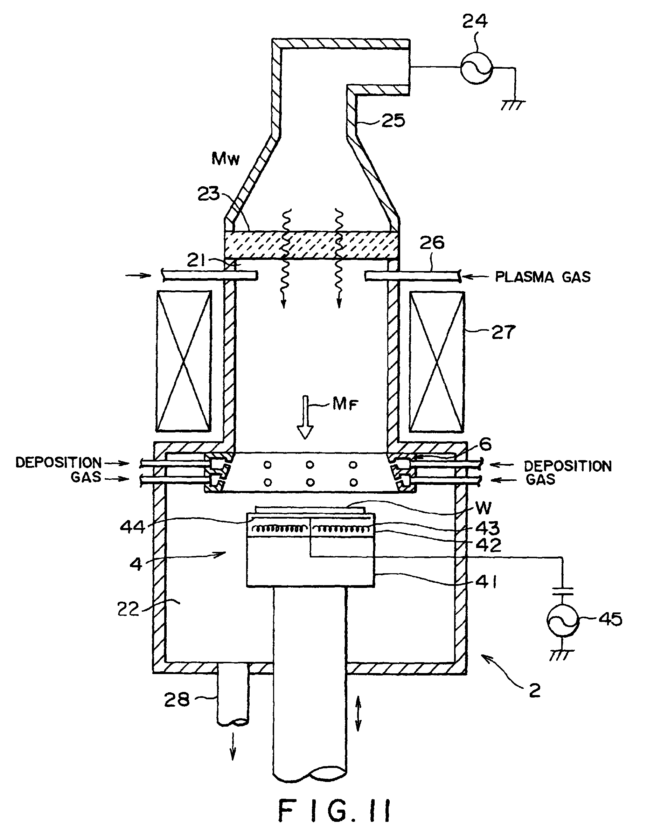

Now, another embodiment of the present invention is described referring to Fig. 10. In this embodiment, the gas supply holes are provided in the external side of a plasma emission zone Pz. Here, the plasma emission zone Pz, meaning a zone in the processing chamber 22 into which the plasma generated in the plasma chamber 21 flows as plasma flow and a zone of which light emission is recognized from outside, is formed in a space over the susceptor 4 extending from the plasma chamber 21 to the processing chamber 22 as shown by the mark Pz in Fig. 10.

In this example, the process gas supply portion 5 is configured similarly to the process gas supply portion 5 in the above-mentioned first embodiment, and the gas supply holes 55 are formed in the inside peripheral surface 50 of the process gas supply portion 5. However, in this example, the inside peripheral surface 50 is located at the position apart from the plasma emission zone Pz. Therefore the gas supply holes 55 are provided in the inside peripheral surface 50 and in the exterior of the plasma emission zone Pz.

This configuration enables to prevent the gas supply holes 55 from being exposed to the plasma. Therefore adhesion of the process gas on the gas supply holes 55 can be avoided, and a throughput of the whole film processing can be improved when the film processing is performed. In other words, if the gas supply holes 55 are provided inside the plasma emission zone Pz, the deposition gas collides with the plasma just after blowing out through the gas supply holes 55 during the deposition gas supply. Therefore a large amount of film deposits around the gas supply holes 55. The large amount of deposition causes peeling of film which becomes particles, and it takes long time to remove the large amount of deposition to prevent particle generation. Therefore, the throughput of the whole film processing decreases.

However, when the gas supply holes 55 are provided outside the plasma emission zone Pz, the deposition gas blowing out through the gas supply holes 55 begins to disperse and collides with the plasma at the area apart from the gas supply holes 61. Therefore the film deposition around the gas supply holes 55 can be avoided. Then since an amount of the film deposition around the gas supply holes 55 considerably decreases, total cleaning time is reduced and the productivity of the whole deposition processing is improved.

Now, another embodiment of the plasma processing apparatus of the present invention is described referring to Fig. 11 through Fig. 16. Difference of the embodiment illustrated in Fig. 11 through Fig. 14 from the embodiment illustrated in Fig. 1 through Fig. 8 is that two types of the process gas are supplied to the processing chamber without mixed inside the ring-shaped process gas supply portion. In addition, an outline of the process gas supply portion 6 is identical to that of the process gas supply portion 5 shown in Fig. 2.

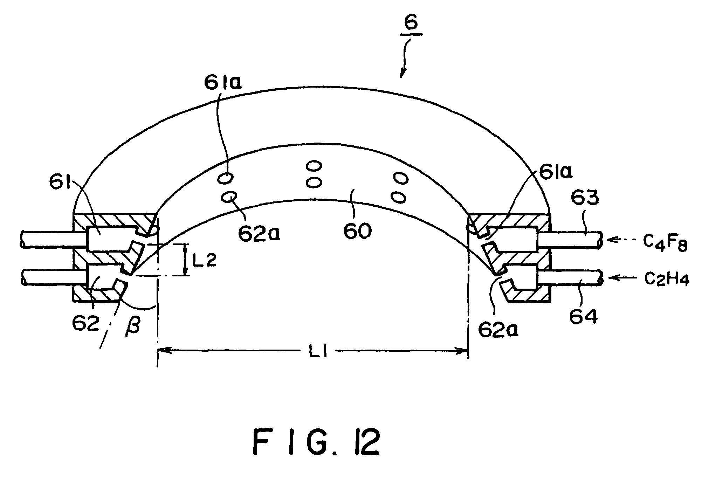

Especially as shown in Fig. 12 in detail, the interior of the hollow ring-shaped process gas supply portion 6 is horizontally divided by a partition wall 6A to form two gas chambers. These two gas chambers play a role of process gas passages in the process gas supply portion 6. The space above the partition wall 6A is a first gas chamber 61, and the space below the wall a second gas chamber 62.

At the positions corresponding to the first gas chamber 61 and the second gas chamber 62 of the inside peripheral surface 60, a plurality of first gas supply holes 61a and a plurality of second gas supply holes 62a are formed and are circumferentially arranged with approximately constant interval. In this example, the first gas supply holes 61a and the second gas supply holes 62a are provided at eight points circumferentially and equally spaced. The first gas supply holes 61a are located inside the pitch circle of the second gas supply holes 62a. The axis of each gas supply hole 61a and 62a diagonally direct downward.

A diameter L1 of the upper end of the inside peripheral surface 60 of the process gas supply portion 6 is set at 300 mm, an inclining angle β of the inside peripheral surface 60 of the process gas supply portion 6 at 45 deg., and a vertical distance L2 between the first gas supply holes 61a and the second gas supply holes 62a at 15 mm. The first gas supply holes 61a are formed at the position 15 mm downward from the upper end of the deposition gas supply portion 6. The first gas supply holes 61a is located at the position about 15 mm inward from the pitch circle of the second gas supply holes 62a. Accordingly the first gas supply holes 61a are located at the position 7.5 mm inward in comparison with conventional gas supply holes and the second gas supply holes 62a are located at the position 7.5 mm outward in comparison with conventional gas supply holes.

And ends of gas supply holes 63 and 64 providing a plurality of, for example, two gas introduction passages almost equally spaced circumferentially are connected to the position each corresponding to the gas chamber 61 and 62 of the outer circumferential surface of the process gas supply portion 6. The other ends of these gas supply pipes 63 and 64 are connected to a gas supply source (not shown).

In addition, although two gas chamber corresponding the case in which two types of the deposition gas are supplied to the processing chamber 22 are shown in the drawing, more number of gas chambers can be provided in the process gas supply portion 6 corresponding to the number of types of the process gas.

Now the case that the deposition processing is performed using two types of the deposition gas, namely the $C_4F_8$ gas and the $C_2H_4$ gas, is considered. The $C_4F_8$ gas and the $C_2H_4$ gas are simultaneously introduced to the deposition gas supply portion 6 through the supply pipe 63 and 64 respectively. At this time, the $C_4F_8$ gas having relatively large specific gravity among the types of the deposition gas is introduced to the upper gas chamber 61 through the gas supply pipe 63. The $C_2H_4$ gas having relatively small specific gravity among the types of the deposition gas is introduced to the lower gas chamber 62 through the gas supply pipe 64. The $C_4F_8$ gas and the $C_2H_4$ gas, circumferentially flowing in the gas chamber 61 and 62 respectively, blow out each from the first gas supply holes 61a and the second gas supply holes 62a toward the zone radially inside the deposition gas supply portion 6, and further toward the wafer F almost equally in the circumferential direction and diagonally downward.

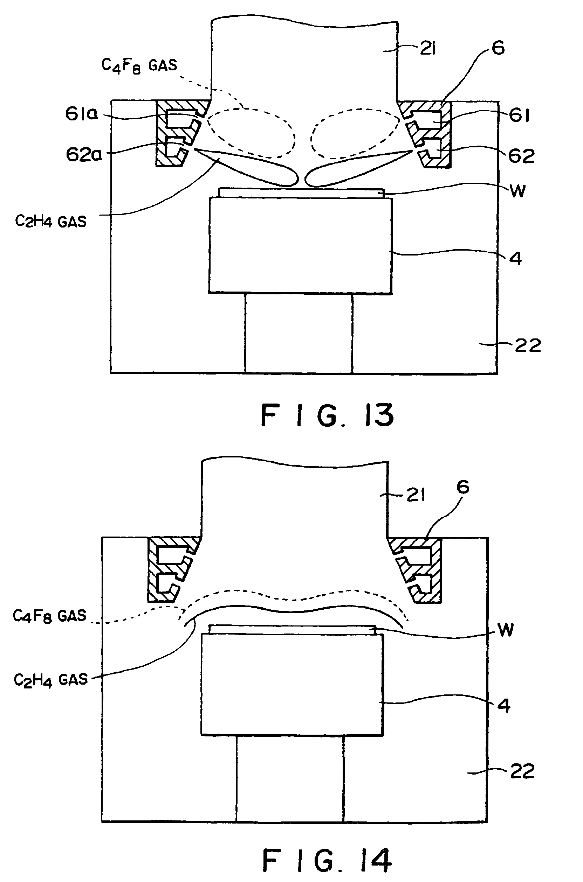

Fig. 13 shows blow-out distribution of the $C_4F_8$ gas and the $C_2H_4$ gas with solid lines and dashed lines respectively. The $C_2H_4$ gas having relatively small specific gravity disperses more easily in the radial direction of the wafer W rather than in the three-dimensionally expanding direction taking the axis of the gas supply hole as a center, and blows out showing beam-shaped blow-out distribution that extends slenderly and diagonally downward. On the other hand, the $C_4F_8$ gas having relatively large specific gravity disperses more easily in the three-dimensionally expanding direction taking the axis of the gas supply hole as a center rather than in the radial direction of the wafer W, and blows out with the blow-out distribution having a shape that expands more widely than the $C_2H_4$ gas.

Here, since the $C_2H_4$ gas blows out through the position farther from the axis of the process gas supply portion than the conventional gas supply holes, the top end of each beam of the $C_2H_4$ gas blowing out through each of the second gas supply holes 62a does not overlap, or slightly overlaps each other, and the gas blows out so as to cover almost all the area over the wafer. Fig. 14 illustrates the $C_2H_4$ gas concentration distribution over the wafer with solid lines. The $C_2H_4$ gas shows almost uniform concentration distribution over the wafer.

On the other hand, the $C_4F_8$ gas blows out through the position nearer toward the axis of the process gas supply portion than the conventional gas supply holes. Therefore, the distance between the gas supply holes 61a and the central axis of the ring-shaped process gas supply portion 6 decreases. And since the first gas supply holes 61a are located higher than the second gas supply holes 62a, it takes longer time for the deposition gas to come down to the wafer surface. Therefore, even if the blow-out distribution has a swelling shape, the top end of the deposition gas reaches the central part of the wafer when the end comes down to the wafer height, and the deposition gas spread all over the wafer. Fig. 14 illustrates the $C_4F_3$ gas concentration distribution over the wafer with dashed lines. The $C_4F_8$ gas shows almost uniform concentration distribution over the wafer.

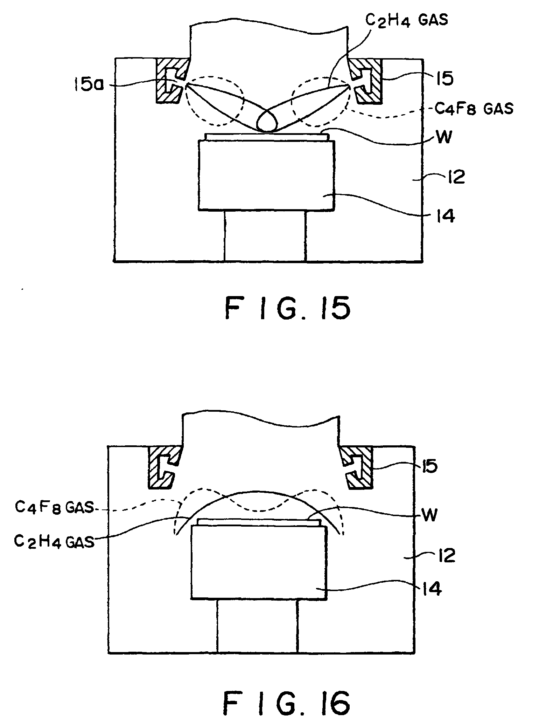

The concentration distribution of the $C_4F_8$ gas and $C_2H_4$ gas obtained from the process gas supply portion above the wafer of this embodiment shows better uniformity than that obtained not from the embodiment. In other words, when a process gas supply portion 15 of the type that the $C_4F_8$ gas and $C_2H_4$ gas are supplied to a processing chamber 12 through the same gas supply holes as shown in Fig. 15 is used, the concentration distribution of each gas over the wafer becomes uneven due to the difference of the directivity of each gas (See Fig. 16).

By grasping the blow-out distribution (directivity) of each deposition gas in advance like this and setting an inclining angle of the inside peripheral surface 60 of the process gas supply portion 6 and positions of the first gas supply hole 61a and the second gas supply hole 62a according to the blow-out distribution, two types of deposition gas having different specific gravity can be supplied in almost uniform concentration distribution of each deposition gas over the wafer even if they are simultaneously supplied from the deposition gas supply portion 6 to the processing chamber 22.

Although the deposition gas supplied over the wafer W is converted into plasma state by the plasma to become the active species, amounts of the active species of carbon and fluorine generated by the plasma becomes almost uniform in the wafer plane because the concentration distribution of each deposition gas are made uniform. As a result the in-plane uniformity of the CF film property can be improved because the concentration distribution of carbon and fluorine in the CF film deposited on the wafer becomes almost uniform in the plane.

In addition, the deposition gas supply portion can be configured by pipes instead of the ring-shaped deposition gas supply portion used in the embodiment shown in Fig. 12. That is to say, the gas supply pipes for the $C_4F_8$ gas supply and the $C_2H_4$ gas supply can be provided along the peripheral of the wafer. In this case, the outlets of the gas supply pipes for the C4F8 gas supply and the $C_2H_4$ gas supply, namely the gas supply holes, may be arranged in the same geometrical manner as the gas supply holes 61a and 61b shown in Fig. 12.

Now a test example performed to verify an effect of this embodiment is described. Using the plasma processing apparatus equipped with the process gas supply portion 6 shown in Fig. 12, Ar gas was supplied to the plasma chamber 21 at a flow rate of 150 sccm, the $C_4F_8$ gas and the $C_2H_4$ gas were supplied from both the first gas chamber and the second gas chamber of the process gas supply portion 6 into the processing chamber 22 at flow rates of 40 sccm and 30 sccm respectively, high frequency power from the high frequency power source and bias power were set at 2700 W and 1500 W respectively, deposition temperature was set at 400°C, and the CF film having film thickness $2\mu$m was deposited on the wafer in a condition similar to that of the above-mentioned embodiment.

The plasma processing apparatus used in this test are configured so that: the diameter L1 of the end of the inside peripheral surface of the deposition gas supply portion 6 is 300 mm; the inclining angle β of the inside peripheral surface 60 of the deposition gas supply portion 6 is 45 deg.; the vertical distance L2 between the first gas supply hole 61a and the second gas supply hole 62a is 15 mm; the first gas supply hole 61a is provided 15 mm below the upper end of the deposition gas supply portion 6; and the second gas supply hole 61a is located at the position about 15 mm nearer to the central axis than the gas supply hole 62a.

And uniformity of the property of the CF film deposited was measured with an Opti-probe (manufactured by Thermawave Co.). As a comparison example, using plasma processing apparatus equipped with a process gas supply portion not relating to this embodiment shown in Fig. 15, the CF film was deposited in a similar process condition, and uniformity of the property of the CF film was measured. As a result, the film processed by the equipment shown in Fig. 12 demonstrated far higher uniformity than that processed by the conventional equipment shown in Fig. 15.

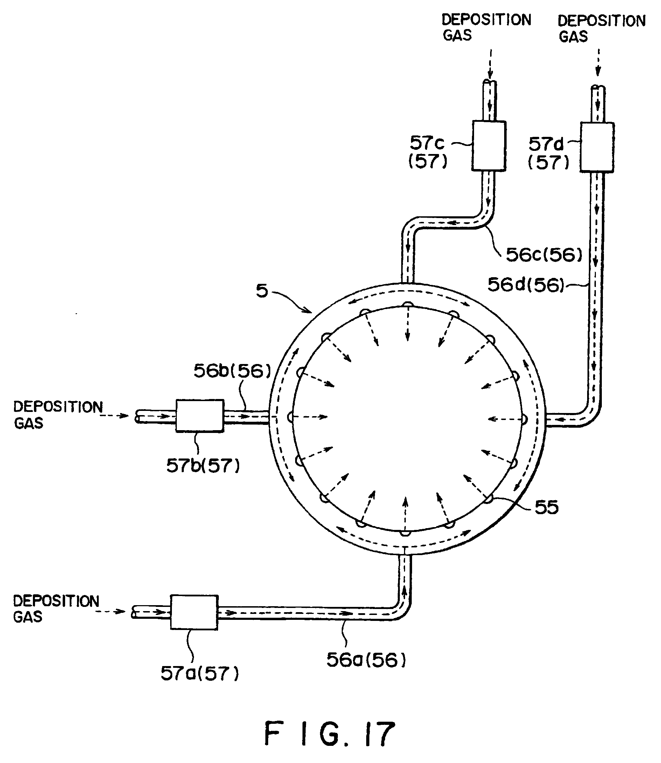

Then another embodiment of the plasma processing apparatus of this invention is further described referring to Fig. 17. The objects of this embodiment are to improve a method for introducing gas to the ring-shaped gas supply portion and to make a blow-out rate through each gas supply hole to be provided in the process gas supply portion constant.

As shown in Fig. 17, a plurality of gas supply pipes, for example four gas supply pipes 56, namely gas introducing passages, are connected to the position circumferentially arranged and almost equally spaced in the outside peripheral surface of the process gas supply portion 5 in this embodiment. And each gas supply pipe is equipped with a mass flow controller 57 (57a through 57d).

A ring-shaped gas chamber, namely a process gas passage, is provided inside the process gas supply portion 5. Gas supply holes 53, namely gas introducing passages, are formed, for example, at 16 positions circumferentially arranged and almost equally spaced in its inside peripheral surface.

In addition, although Fig. 17 shows the gas supply pipes 56 in case that a type of deposition gas is supplied to the processing chamber 22, the gas supply pipes 56 for the other type of process gas corresponding to the types of the process gas to be supplied to the processing chamber 22 may be provided. In this case, each gas supply pipe is equipped with the mass flow controller.

In this embodiment, for example, all types of the deposition gas (for example the $C_4F_8$ gas and the $C_2H_4$ gas) are supplied to the processing chamber 22 through the process gas supply portion 5. In this case, the deposition gas is supplied to the process gas supply portion 5 in a condition that its flow rate is controlled by the mass flow controller 52, flows while dispersing in the process gas supply portion 5, and blows out to the processing chamber 22 through each gas supply hole 53 at an almost uniform flow rate.

In other words, since each gas supply pipe 56 is equipped with the mass flow controller 57, if the deposition gas is supplied, for example, at a flow rate of 100 sccm, and when the flow rate of the deposition gas is controlled at 25 sccm by each mass flow controller, the deposition gas flows through each gas supply pipe at the controlled flow rate, and is supplied through four positions circumferentially arranged and equally spaced in the outside peripheral surface at a flow rate of 25 sccm per position.

Accordingly in this embodiment, since the flow rate of the deposition gas at the downstream side of the mass flow controller 57 of each gas supply pipe 56 is controlled at a constant value even if gas line length of each gas supply pipe 56 is different from each other, the deposition gas is supplied to the deposition gas supply portion 5 through each gas supply pipe 56 at the same flow rate. Therefore in comparison with the case that the flow rate of the deposition gas supplied through each gas supply hole varies depending on the gas line length like the case (see Fig. 26) that the gas supply pipe is branched off to two pipes at the downstream side of the mass flow controller in the conventional plasma processing apparatus, the uniformity of the blow-out distribution of the deposition gas through the gas supply holes 53 can be improved.

In addition, in this embodiment, when the number of the gas supply pipes 56 is increased, the deposition gas is supplied to the deposition gas supply portion 5 at the same flow rate through a number of positions equally spaced in the circumferential direction. Therefore deposition gas pressure in the deposition gas supply portion 5 easily becomes uniform circumferentially, and the blow-out distribution of the deposition gas through gas supply holes 56 becomes more uniform.

Therefore, even if the necessity to increase the gas flow rate to deal with enlargement of size of the wafer W arises, the uniformity of the blow-out distribution of the deposition gas through gas supply holes 56 can be improved. And such uniformity of the blow-out distribution of the deposition gas brings the effect that the plasma of the deposition gas generated by the plasma flow can easily become uniform directly above the wafer W, and also the in-plane uniformity the film thickness of the CF film to be generated on the wafer W can be improved.

Now, a test example performed to verify the effect of this embodiment is described.

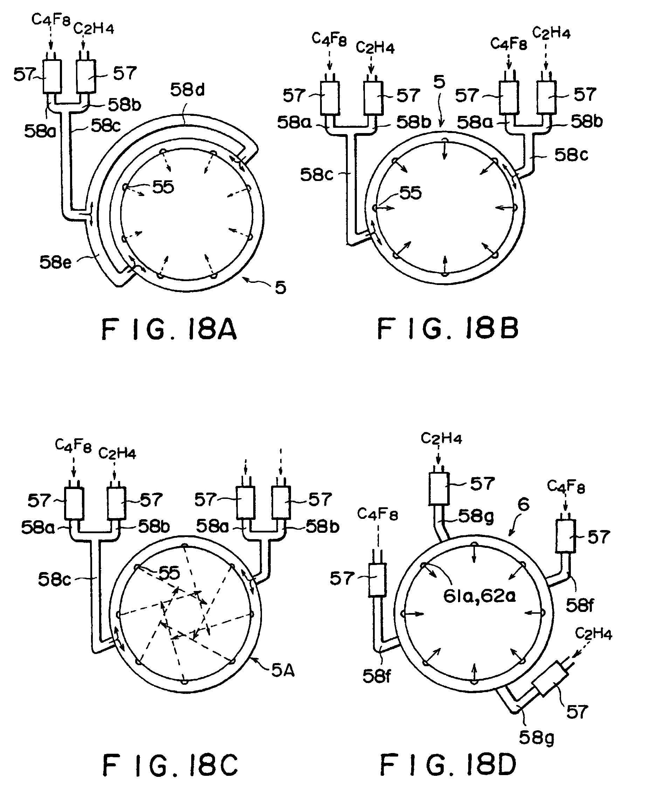

Four types of plasma equipment having different configuration of the gas supply portion and the gas supply pipes 56 to be connected to that portion (see Fig. 18A through Fig. 18D) were prepared. Hereafter the plasma equipment provided with gas supply means shown in Fig. 18A, Fig. 18B, Fig. 18C and Fig. 18D are referred to as equipment A, equipment B, equipment C and equipment D respectively.

Configuration of the gas supply portion 5 of the equipment A and the equipment B are substantially identical to the gas supply portion 5 shown in Fig. 2. In these equipment A and equipment B, the geometrical relation between the axis of each gas supply hole of the gas supply portion and the wafer W is identical to that of the embodiment shown in Fig. 2. Further, the eight gas supply holes were provided.

And the configuration of the gas supply portion of the equipment C is identical to that of the gas supply portion shown in Fig. 9. Only one ring-shaped space is formed inside the gas supply portion 5.

Now gas supply system in the equipment A through D is described.

Firstly, in the equipment A, a pair of the gas supply pipes 58a and 58b connected to $C_4F_8$ gas supply source and $C_2H_4$ gas supply source (not shown) respectively are provided with the mass flow controller 57 respectively. Both of the gas supply pipes 58a and 58b join into one gas supply pipe 58c at the downstream side of the mass flow controller 57. The gas supply pipe 58c further branches off to two pipes 58d and 58e which are connected to the gas supply portion at opposite positions 180 deg. apart. This configuration is substantially identical to the conventional one.

In the equipment B and C, the gas supply pipe 58c is connected to the ring-shaped gas supply portion 5 at the opposite position 180 deg. apart without branching off at the downstream side of the mass flow controller 58. In other words, the mass flow controllers of which number (in this example four) is obtained by multiplying the number of the connecting points of the gas supply pipes and the ring-shaped gas supply portions (in this example two) by the number of the types of process gas to be used (In this example two) are provided.

And the gas supply portion of the equipment D is formed based on the embodiment shown in Fig. 12. That is to say, two gas chambers (not shown in Fig. 18D) is formed inside the gas supply portion 5, and the upper gas chamber and the lower gas chamber are used to supply the $C_4F_3$ gas and the $C_2H_4$ gas respectively. Here a pair of gas supply pipes 58f and 58f exclusively used for the $C_4F_8$ gas are connected to the ring-shaped gas supply portion at the opposite position 180 deg apart, and a pair of gas supply pipes 58g and 58g exclusively used for the $C_2H_4$ gas are connected to the ring-shaped gas supply portion at the opposite position 180 deg apart. Connecting position of the gas supply pipe 58f exclusively used for the $C_4F_8$ gas in the gas supply portion 5 is displaced by 90 deg from the connecting position of the gas supply pipe 58g exclusively used for $C_2H_4$ gas. Each of the gas supply pipes 58f and 58g are equipped with the mass flow controller 57 respectively. In addition, the number of the gas supply holes provided in the inside peripheral surface of the gas supply portion 6 is eight and eight for the $C_4F_8$ gas and the $C_2H_4$ gas respectively, namely total 16.

Using the plasma processing apparatus provided with the deposition gas supply portion 5 shown in the equipment A through D, the Ar gas was supplied to the plasma chamber 21 at a flow rate of 150 sccm, the $C_4F_8$ gas and the $C_2H_4$ gas were supplied from the deposition gas supply portion 5 or 6 to the processing chamber 22 at flow rates of 40 sccm and 30 sccm respectively, the high frequency power from the high frequency power source 24 was set at 2700 W, the bias power at 1500 W, the deposition temperature at 400°C, and the CF film having the film thickness of 2μm was deposited on the wafer in the same process condition as that of the above-mentioned embodiment.

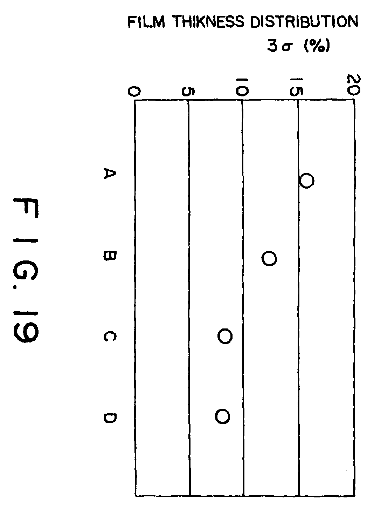

And the uniformity of the CF film thickness deposited was measured by the Opti-probe (manufactured by Thermawave Co.). The result of evaluation of the uniformity using the aforementioned 3 σ method based on these measurement results are shown in Fig. 19. In addition, the marks A, B, C and D in Fig. 19 show the results obtained from the equipment A, B, C and D respectively.

As shown in the chart of Fig. 19, the uniformity of the film thickness of the equipment having the gas supply means based on this embodiment is improved in comparison with that of the equipment A having the conventional configuration. In other words, it was ensured that, when each gas supply pipe is equipped with the mass flow controller, the blow-out distribution from the deposition gas supply portion becomes uniform, and the uniformity of the CF film thickness is improved.

And the uniformity of the CF film thickness deposited by the equipment C and D is further improved than that by the equipment B.

Here the other embodiment of the plasma processing apparatus of the present invention is further described. Main object of the following embodiment is to improve thermal stability of the CF film, and the main feature is to supply a part of the deposition gas to the plasma chamber.

In the plasma processing apparatus shown in Fig. 20, a part of a plurality of gas nozzles 26 is assigned for plasma gas supply and the remaining for the deposition gas supply. The deposition gas source or the plasma gas source (not shown) is connected to each gas nozzle 26 according to its application. The gas nozzle 26 can supply a part of or all the plasma gas such as the Ar gas and $O_2$ gas and the deposition gas such as $C_nF_m$ gas, for example $C_4F_8$ gas, and $C_kH_s$ gas, for example $C_2H_4$ gas to the upper part inside the plasma chamber 21 uniformly without unevenness. The configuration of the other parts is identical to the plasma processing apparatus shown in Fig. 1 and Fig. 11.

When magnet field Mf having the specified intensity and direction is produced inside the vacuum vessel 2, and the microwave Mw having controlled frequency is introduced to the plasma chamber 21, the plasma is generated by an interaction of these, and plasma density of this plasma becomes maximum at, for example, an ECR point Pe close to the boundary between the plasma chamber 21 and the processing chamber 22. This ECR point Pe means a zone where the ECR plasma condition is established. And high density plasma is formed by the generation of resonance in the Ar gas introduced by this plasma.

Now performance of the above-mentioned equipment in case that inter-level isolation film consisting of the CF film is formed on the wafer W, the substrate to be processed, is described. Firstly a gate valve (not shown) installed on the side wall of the vacuum vessel 2 is opened, the wafer W on which surface, for example, aluminum wiring is formed is carried in from a load lock chamber (not shown) and placed on the susceptor 4 by a carrying arm (not shown).

Then after the gate valve is closed to keep the interior gas-tight, internal atmosphere is exhausted through an exhaust pipe 28 to achieve the specified vacuum pressure, the plasma gas, for example, Ar gas is introduced at a flow rate of 150 sccm and the $C_n f_m$, gas, for example, the $C_4F_8$ gas among the deposition gas is introduced at a flow rate of 40 sccm both through the gas nozzles 26 to the plasma chamber 21. And the $C_kH_s$ gas, for example, the $C_2H_4$ gas is introduced from the process gas supply portion 5 to the processing chamber 22 at a flow rate of 30 sccm.

The introduced gas flows downward inside the plasma chamber 21 by an exhaust action of the exhaust pipe 28. And a process pressure in the vacuum vessel 2 is maintained at, for example, 016 Pa, the bias voltage at 13.56 MHz and 1500 W is applied to the susceptor 4 by the high frequency power source portion 45, and the surface temperature of the susceptor 4 is set at 400°C.

On the other hand, the high frequency (microwave) Mw at 2.45 GHz and 2700 W is introduced from the high frequency power source portion 24 to the plasma chamber 21 through the wave guide 25 and the transmission window 23, and the magnet field Mf directing downward at, for example, 875 Gauss is applied to the plasma chamber 21 by the electromagnetic coil 27 and the auxiliary electromagnetic coil. By this, in the plasma chamber 21, E (electric field) x H (magnetic field Mf) is induced by the interaction of the magnetic field Mf and the microwave Mw to generate the electron cyclotron resonance, then the plasma is generated, and the plasma density becomes maximum at the ECR point Pe. This resonance results in the conversion from Ar gas to a plasma and the increase of the plasma density.

The generated plasma flows from the plasma chamber 21 into the processing chamber 22 as the plasma flow. At this time, the $C_4F_8$ gas flows downward from the upper side of the ECR point Pe passing through the plasma. And the $C_4F_8$ gas is activated (converted into plasma state) by this plasma during passing through the plasma to form the active species (plasma). And the $C_2H_4$ gas forms the activated species by the plasma flow that flows into the processing chamber 22. On the other hand, the plasma ion, in this example, Ar ion, is pulled into the wafer W by the bias voltage, and cuts off an edge of the pattern (concave part) on the surface of the wafer W to increase width, the CF film is deposited by the plasma of the deposition gas and embedded in the concave part along with the spatter etching action to form the inter-level isolation film consisting of the CF film.

The $C_4F_8$ gas introduced from the upper side of the ECR point Pe where the $C_4F_8$ gas is generated passes the ECR point Pe while flowing toward the wafer W with the plasma by the time when the deposition gas reaches the surface of the wafer W. Therefore the $C_4F_8$ gas passes the ECR point Pe where the plasma density is highest. And since the zone where the $C_4F_8$ gas contacts with the plasma is wide because it extends from the zone where the plasma is generated to the zone directly above the wafer W, the $C_4F_8$ gas contacts with the plasma for a long time. Therefore, the conversion of the $C_4F_8$ gas into active species (plasma state) by the plasma is sufficiently promoted, and the thermal stability of the CF film deposited on the wafer W is improved.

The CF film actually deposited by the above-mentioned equipment was annealed for two hours at 425°C, and it was found that about 2% of fluorine is removed as gas. Thus it was confirmed that the thermal stability is higher than that of the conventional equipment.

The reason why the thermal stability is improved like this is considered to be as follows:

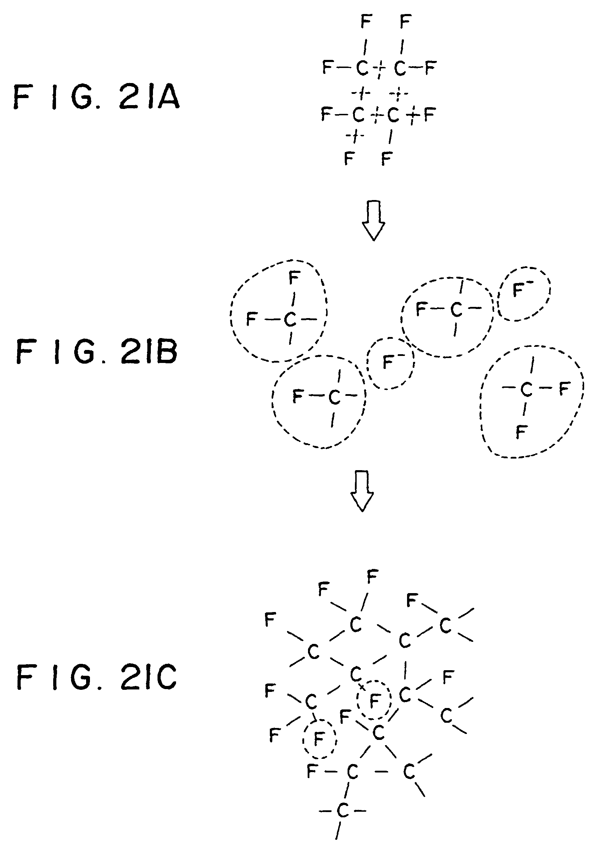

When the $C_4F_8$ gas, a part of the deposition gas, is sufficiently converted into plasma state by the plasma as mentioned above, C-C bonding and C-F bonding of the $C_4F_8$ molecule are cut off as shown in Fig. 21, and the dissociation of the $C_4F_8$ molecule increases (See Fig. 21A). Therefore, the activated species of carbon and fluorine having non-bonding arm as shown in Fig. 21B increases. In such condition, the carbon can easily bond with each other on the CF film deposited on the wafer W, and three-dimensional network structure of the C-C bonding can be easily formed (See Fig. 21C).

The creation of the network structure like this results in the decrease of the number of the activated species in the CF film, which becomes stronger than before. Therefore when the CF film is heated till a temperature higher than the deposition temperature, for example, till approximately 425°C, an amount of the fluorine separated from unstable species is small, and dissociated fluorine (fluorine surrounded by dashed lines in Fig. 21C) scarcely escapes from the network structure even if a part of the C-F bonding is dissociated by this heat. This is considered to improve the thermal stability of the CF film.

Now, this CF film is compared with that formed by the conventional plasma processing apparatus. Conventionally, all the deposition gas is introduced to the processing chamber, the plasma flow generated in the plasma chamber flows into the processing chamber and contacts with the deposition gas introduced here, and the deposition gas is converted into plasma state by this. Therefore, the $C_4F_8$ gas cannot pass the ECR point Pe, and the zone where the gas contacts with the plasma is restricted to the zone above the wafer in the processing chamber. Consequently the time during which $C_4F_8$ gas contacts with the plasma becomes considerably shorter than this embodiment.

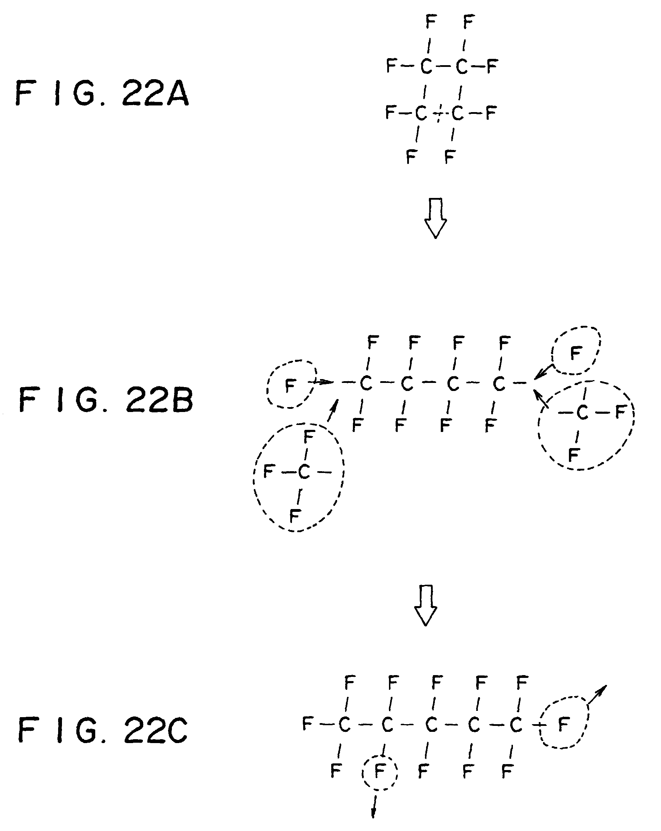

Therefore, the $C_4F_8$ gas is not sufficiently converted into plasma state, and this insufficiently converted $C_4F_8$ gas is acquired by the CF film. If the dissociation of the $C_4F_8$ molecule is small due to the insufficient conversion (to plasma state), for example in such a case that only one of the C-C bonding is dissociated even if the $C_4F_8$ gas converted into plasma state (as shown In Fig. 22A), the C-C bonding is likely to be arranged as a linear chain (See Fig. 22B).

In this type of the linear chain structure, the carbon or the fluorine is bonded with the carbon having non-bonding arm at the end. However, since the number of the active species capable of bonding with the carbon at the end is small, the number of the non-bonding active species in the CF film increases. Therefore when the CF film is heated till high temperature, the fluorine easily escapes from the unstable species. And when the C-C bonding or the C-F bonding is cut off to generate solution or separation of the fluorine, the separated fluorine (fluorine surrounded by dashed lines in Fig. 22C) cannot easily confined within the CF film due to its linear chain one-layer structure. Therefore, it is considered that the fluorine escapes more easily than this embodiment, and the thermal stability is poor.

Now a test performed to verify the effect of this embodiment is described. Using the plasma processing apparatus shown in Fig. 20, the Ar gas, the $C_4F_8$ gas and $C_2H_4$ gas were supplied at flow rates of 150 sccm, 40 sccm and 30 sccm respectively, the high frequency power was set at 2700 W, and the bias power at 1500 W and the deposition temperature at 400°C to deposit the CF film having a thickness of 2μm on the wafer in the similar process condition as the above-mentioned embodiment. The process gas was supplied to the plasma chamber 21 or the processing chamber 22 as shown in Table 2 below.

Then the wafer provided with the CF film was once cooled down to room temperature, was subjected to heat treatment by keeping it in nitrogen atmosphere at 425°C for two hours, and cooled down to the room temperature in natural atmosphere. The thermal stability was compared based on a film reduction ratio before and after the heat treatment that is defined as [{(CF film weight before heat treatment)-(CF film weight after heat )treatment)}/(CF film weight before heat treatment)] x 100 . In this case, the lower the film reduction ratio becomes, the lower an amount of escaped fluorine becomes and the higher the thermal stability becomes.

In this test,

Example 1 is a case that the Ar gas and the $C_4F_8$ gas are supplied to the plasma chamber 21 and the $C_2H_4$ gas is supplied to the processing chamber 22;

Example 2 is a case that the Ar gas and the $C_2H_4$ gas are supplied to the plasma chamber 21 and the $C_4F_8$ gas is supplied to the processing chamber 22;

Example 3 is a case that the Ar gas, $C_4F_3$ gas and the $C_2H_4$ gas are supplied to the plasma chamber 21; and

Comparative example 1 is a case that the Ar gas is supplied to the plasma chamber 21 and the $C_4F_8$ gas and the $C_2H_4$ gas are supplied to the processing chamber 22.

The results are shown in Table 2.

Table 2

| | Gas introducing port | | |
| --- | --- | --- | --- |
| | Plasma chamber | Deposition chamber | Film reduction ratio (%) |
| Example 1 | Ar and $C_4F_8$ | $C_2H_4$ | 2.2 |
| Example 2 | Ar and $C_2H_4$ | $C_4F_8$ | 3.5 |
| Example 3 | Ar,$C_2H_4$ and $C_4F_8$ | - | 1.8 |
| Comparative Example 1 | Ar | $C_4F_8$ and $C_2H_4$ | 4.1 |

As shown in Table 2, when a part of the deposition gas is introduced to the plasma chamber (Example 1 and 2), the film reduction ratio becomes lower than that of Comparative example 1. Therefore it was confirmed that when a part of the deposition gas is introduced to the plasma chamber, an amount of escaped fluorine is small and the thermal stability is improved. In this case, when Example 1 and 2 are compared, the film reduction ratio of Example 1 is lower than that of Example 2. Therefore it was confirmed that it is preferable to introduce the $C_nF_m$ gas, at least one of the deposition gas, to the plasma chamber 21. And when all the deposition gas is introduced to the plasma chamber 21 (Embodiment 3), the film reduction ratio becomes 1.8%. Therefore it was confirmed that it is more preferable to introduce all the deposition gas into the plasma chamber 21.

Thus, in this embodiment, the $C_nF_m$ gas (n is an integer equal to or larger than 1, and m is an integer equal to or larger than 2) such as $CF_4$ gas, $C_4F_6$ gas, $C_4F_8$ gas, $C_6F_{10}$ gas, $C_6F_6$ gas and $C_7F_8$ gas can be used, and the $C_kH_s$ gas (k is an integer equal to or larger than 1, or equal to 0, and s is an integer equal to or larger than 2) such as $H_2$ gas, $C_2H_2$ gas, $C_2H_4$ gas and $CH_4$ gas can be used. In addition, it is possible to supply the $C_kH_s$ gas among the deposition gas to the plasma chamber 21 and supply the $C_nF_m$ gas to the deposition chamber, namely the processing chamber 22, and also it is possible to supply all the deposition gas into the plasma chamber 21. Further it is possible to supply he deposition gas to the plasma chamber 21 and the processing chamber by distributing the gas at a desired rate, for example, to supply 30 sccm of $C_4F_8$ gas among 40 sccm to the plasma chamber 21 and 10 sccm to the processing chamber 22.

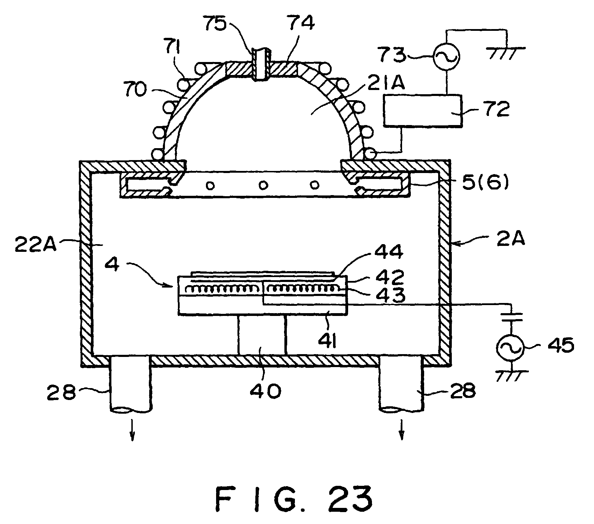

In the above-mentioned the first through the sixth embodiment, although the case that the ECR plasma processing apparatus is used as the plasma processing apparatus was described, plasma generation system is not limited to the ECR. That is to say, it may be induction bonding plasma processing apparatus as shown in Fig. 23. In the induction bonding plasma processing apparatus shown in Fig. 23, a plasma chamber 21B is divided by a semi-sphere-shaped dome 70. An induction coil 71 is wound along an external surface of the dome70. The induction coil 71 is connected to a high frequency power source 73 through a rectifier 72. An anode 74 can be installed on the top of the dome 70.

The processing chamber side of the induction bonding plasma processing apparatus shown in Fig. 23 can be configured according to the ECR plasma processing apparatus described so far. Therefore in the induction bonding plasma processing apparatus shown in Fig. 23, configuration of the aforementioned ring-shaped process gas supply portion 5, 5A and 6 (Fig. 2 through Fig. 6, Fig. 9, Fig. 10 and Fig. 12) is applicable as a process gas supply portion. And configuration shown in Fig. 17 and Fig. 18 is applicable as a gas supply pipe arrangement.

In addition, an introducing port 75 for supplying a part of the plasma gas can be installed on the top of the dome 70.

Furthermore, an introducing port 75 for supplying a part of the process gas can be additionally installed on the top of the dome 70. When deposition processing of the CF film is per formed, it is possible to promote conversion of the $C_nF_m$ gas into plasma state to obtain the CF film having high thermal stability by introducing the plasma gas and a part of the deposition gas, preferably the $C_nF_m$ gas (n is an integer equal to or larger than 1, and m is an integer equal to or larger than 2) to the plasma chamber 21B through this introducing port 75 in a similar manner as the embodiment described using Fig. 20.

When this invention is applied to the induction bonding plasma processing apparatus as shown in Fig. 23, a similar effect is obtained.

In addition, although a case that the deposition processing is performed by the plasma processing apparatus was described above, the plasma processing apparatus of this invention can be applied to a case of etching processing, for example, a case of etching silicon oxide film using CF type gas.

Various types of the embodiment of this invention were described referring to Fig. 1 through Fig. 23 so far, and it is naturally possible to configure the plasma processing apparatus by properly combining the features disclosed in each drawing.

**Claims**

1. A Plasma processing apparatus comprising:

   a plasma chamber for producing a plasma;
   a processing chamber connected to the plasma chamber, to which the plasma produced in the plasma chamber is introduced;
   a plasma gas introducing means for introducing the plasma gas into the plasma chamber;
   a susceptor arranged in the processing chamber, on which a substrate to be processed is placed; and
   a process gas introducing means for the processing chamber including a plurality of process gas introducing ports for supplying process gas into the processing chamber;
   wherein each of the gas introducing ports has an axis that diagonally crosses a plane including a surface of the substrate to be processed that is placed on the susceptor at a crossing angle.

2. The plasma processing apparatus according to claim 1, wherein each of the process gas introducing ports has an outlet end facing the processing chamber, and wherein a cross-sectional area of each of the gas introducing ports increases as it approaches of an outlet end thereof.

3. The plasma processing apparatus according to claim 2, wherein an internal space of each of the gas introducing ports has a truncated cone shape.

4. The plasma processing apparatus according to any one of claims 1 to 3, wherein the axes of the gas supply ports cross each other at a position, the position being located on a normal line at a center of the surface to be processed of the substrate placed on the susceptor, and the position being a distance apart in a direction from the surface to be processed toward the plasma chamber.

5. The plasma processing apparatus according to claim 4, wherein the angle between the axis of each of the gas introducing ports and the plane including the surface to be processed of the substrate is 15 to 65 (deg.), and

the distance from the surface to be processed to the position where the axes of the respective gas introducing ports cross each other is 5 to 15 (mm).

6. The plasma processing apparatus according to claim 4, wherein the angle between the axis of each of the gas introducing ports and the plane including the surface to be processed of the substrate is 30 to 45 (deg.), and

the distance from the surface to be processed to the position where the axes of the respective gas introducing ports cross each other is 5 to 10 (mm).

7. The plasma processing apparatus according to any one of claims 1 to 3, wherein the axis of each of the gas introducing ports does not cross a normal line at a center of a surface to be processed of the substrate placed on the susceptor.

8. The plasma processing apparatus according to any one of claims 1 to 3, wherein the outlet end of each of the gas introducing ports is located at an exterior of a plasma emission zone.

9. The plasma processing apparatus according to any one of claims 1 to 3, wherein the process gas introducing means for the processing chamber comprises a hollow ring body having an inside peripheral surface, the body having a ring shape taking a normal line at the center of the substrate to be processed placed on the susceptor as a central axis,

wherein a process gas passage for passing the process gas is formed inside the ring body, the process gas passage circumferentially extending along the ring body, and

wherein the process gas passage of the ring body is connected to each of the gas introducing ports and opens into the inside peripheral surface.

10. The plasma processing apparatus according to claim 9 further comprising:

a plurality of gas introducing passages connected, with intervals with respect to a circumferential direction of the process gas passage, to the process gas passage of the ring body; and

a flow rate controller provided in each of the gas introducing passages.

11. The plasma processing apparatus according to any one of claims 1 to 3, further comprising the process gas introducing means for the plasma chamber for supplying the process gas to the plasma chamber,

wherein the process gas supplied to the plasma chamber by the process gas introducing means for the plasma chamber is converted to an active species in the plasma chamber.

12. The plasma processing apparatus according to claim 11, wherein the process gas supplied to the plasma chamber by the process gas introducing means for the plasma chamber has the same composition as the process gas supplied to the processing chamber by the process gas introducing means for the processing chamber.

13. The plasma processing apparatus according to claim 11, wherein the process gas supplied to the plasma chamber by the process gas introducing means for the plasma chamber has a different composition from that of the process gas supplied to the processing chamber by the process gas introducing means for the processing chamber.

14. The plasma processing apparatus according to claim 11. wherein the process gas supplied to the plasma chamber by the process gas introducing means for the plasma chamber is a $C_nF_m$ gas (n is an integer equal to or larger than 1, and m is an integer equal to or larger than 2).

**15.** The plasma processing apparatus according to claim 11, wherein the plasma processing apparatus is an ECR plasma processing apparatus including means for supplying microwave into the plasma chamber and means for generating magnetic field in the plasma chamber, and

wherein an outlet end of each of the gas introducing ports of the process gas introducing means for the plasma chamber is located at a side opposite from the processing chamber with respect to a zone within the plasma chamber where an electron cyclotron resonance condition can be established.

**16.** The plasma processing apparatus according to any one of claims 1 to 3, wherein the gas introducing ports of the process gas introducing means for the processing chamber include a first gas introducing port and a second gas introducing port located at a position lower than the first gas introducing port, the first and second gas introducing ports being arranged so that the distance from a normal line at a center of a surface to be processed of the substrate to be placed on the susceptor to an outlet end of the first gas introducing port is larger than that from the normal line to the outlet end of the first gas introducing port, and

wherein a specific gravity of the process gas supplied through the first gas introducing port is greater than that of the process gas supplied through the second gas introducing port.

**17.** The plasma processing apparatus according to claim 16, wherein the process gas introducing means for the processing chamber comprises a hollow ring body having an inside peripheral surface, the body having a ring shape taking a normal line at the center of the substrate to be processed placed on the susceptor as a central axis, the body having an inside peripheral surface inclining against a direction of the normal line,

wherein the first and the second process gas passages are provided inside the ring body and extends circumferentially along the ring body, and the first and the second process gas passages are separated each other so as to prevent the gas from passing from one passage to another,

the first gas introducing port is connected to the first process gas passage, and has an opening in the inside peripheral surface of the ring body,
the second gas introducing port is connected to the second process gas passage, and has an opening in the inside peripheral surface of the ring body.

**18.** A plasma processing method comprising the steps of:

placing a substrate to be processed on the susceptor arranged in a processing chamber;
supplying a process gas from a plurality of positions to a surface to be processed of the substrate in directions diagonally crossing a plane including the surface; and
ionizing the process gas to produce a plasma, and performing a process on the substrate by the plasma.

**19.** The method according to claim 18, wherein the process to be performed on the substrate by a plasma processing apparatus is a deposition process.

**20.** The method according to claim 18, wherein the process to be performed on the substrate by a plasma processing apparatus is an etching process.

FIG. 1

F I G. 2

F I G. 3

F I G. 4

F I G. 5

F I G. 6

F I G. 7

F I G. 8

F I G. 9

F I G. 10

24

25

Mw

23

21

26

PLASMA GAS

27

MF

DEPOSITION GAS

DEPOSITION GAS

6

W

44

43

42

4

41

22

45

28

2

FIG. 11

F I G. 12

EP 1 063 690 A1

C₄F₈ GAS

61a

62a

C₂H₄ GAS

21

6

61

62

W

4

22

# F I G. 13

C₄F₈ GAS

C₂H₄ GAS

21

6

W

4

22

# F I G. 14

F I G. 15

F I G. 16

F I G. 17

F I G. 18A

F I G. 18B

F I G. 18C

F I G. 18D

F I G. 19

DEPOSITION GAS
PLASMA GAS

DEPOSITION GAS

F I G. 20

F I G. 2IA

F I G. 2IB

F I G. 2IC

FIG. 22A

FIG. 22B

FIG. 22C

F I G. 23

F I G. 24

F I G. 25

F I G. 26

# INTERNATIONAL SEARCH REPORT

| International application No. |
| --- |
| PCT/JP99/01079 |

**A. CLASSIFICATION OF SUBJECT MATTER**
Int.Cl⁶ H01L21/31, H01L21/205

According to International Patent Classification (IPC) or to both national classification and IPC

**B. FIELDS SEARCHED**

Minimum documentation searched (classification system followed by classification symbols)
Int.Cl⁶ H01L21/31, H01L21/205

Documentation searched other than minimum documentation to the extent that such documents are included in the fields searched

| | | | |
| --- | --- | --- | --- |
| Jitsuyo Shinan Koho | 1922-1996 | Toroku Jitsuyo Shinan Koho | 1994-1999 |
| Kokai Jitsuyo Shinan Koho | 1971-1999 | Jitsuyo Shinan Toroku Koho | 1996-1999 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| | JP, 3-218018, A (Sony Corp.), 25 September, 1991 (25. 09. 91) (Family: none) | |
| X | Full text ; Figs. 1 to 5 | 1, 4, 8, 9, 15, 18-20 |
| Y | Full text ; Figs. 1 to 5 | 16, 17 |
| A | Full text ; Figs. 1 to 5 | 11-13 |
| | Microfilm of the specification and drawings annexed to the request of Japanese Utility Model Application No. 2-103640 (Laid-open No. 4-60556) (The Japan Steel Works,Ltd.), 3 October, 1990 (03. 10. 90) (Family: none) | |
| X | Full text ; Figs. 1 to 9 | 1, 7, 8, 9, 15, 18, 19 |
| Y | Full text ; Figs. 1 to 9 | 4, 5, 6 |

| [X] Further documents are listed in the continuation of Box C. | [ ] See patent family annex. |
| --- | --- |

| | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | | |
| "O" | document referring to an oral disclosure, use, exhibition or other means | "Y" | document of particular relevance; the claimed invention cannot be considered to involve an inventive step when the document is combined with one or more other such documents, such combination being obvious to a person skilled in the art |
| "P" | document published prior to the international filing date but later than the priority date claimed | "&" | document member of the same patent family |

| Date of the actual completion of the international search 1 June, 1999 (01. 06. 99) | Date of mailing of the international search report 8 June, 1999 (08. 06. 99) |
| --- | --- |
| Name and mailing address of the ISA/ Japanese Patent Office | Authorized officer |
| Facsimile No. | Telephone No. |

Form PCT/ISA/210 (second sheet) (July 1992)